# EUROPEAN PATENT SPECIFICATION

(11) **EP 4 036 057 B1**
(45) Date of publication and mention of the grant of the patent: **07.12.2022**
(21) Application number: 21461506.4
(22) Date of filing: 12.01.2021
(51) Int. Cl.: C01B 19/00, H01L 35/00, H01L 35/16

(54) **A METHOD OF OBTAINING BULK PBTE-CDTE NANOCOMPOSITE**
VERFAHREN ZUR HERSTELLUNG VON PBTE-CDTE-BULKNANOKOMPOSIT
PROCÉDÉ D'OBTENTION DE NANOCOMPOSITE PBTE-CDTE EN VRAC

(43) Date of publication of application: 03.08.2022
(73) Proprietor: Instytut Fizyki Polskiej Akademii Nauk, 02-668 Warszawa (PL); PUREMAT Technologies, 02-668 Warszawa (PL)
(72) Inventor: Szot, Michal, 02-668 Warszawa (PL); Dybko, Krzysztof, 02-668 Warszawa (PL); Story, Tomasz, 02-668 Warszawa (PL); Mycielski, Andrzej, 02-668 Warszawa (PL)
(74) Representative: Bury & Bury

(56) References cited:
- WO-A2-2006/133031
- HORICHOK I V ET AL: "Point defects in PbCdTe solid solutions", JOURNAL OF APPLIED PHYSICS, AMERICAN INSTITUTE OF PHYSICS, US, vol. 127, no. 5, 4 February 2020 (2020-02-04), XP012244375, ISSN: 0021-8979, DOI: 10.1063/1.5130747 [retrieved on 2020-02-04]
- ORLOWSKI B A ET AL: "Photoemission spectra of frozen rock salt PbCdTe crystal", JOURNAL OF ELECTRON SPECTROSCOPY AND RELATED PHENOMENA, vol. 184, no. 3, 1 December 2010 (2010-12-01), pages 199-202, XP028220090, ISSN: 0368-2048, DOI: 10.1016/J.ELSPEC.2010.12.029 [retrieved on 2010-12-31]

## Description

### Field of the invention

The invention concerns a method of obtaining PbTe-CdTe nanocomposite for production of thermoelectric energy converters, particularly for thermoelectric generators working at high- and mid-temperature conditions.

### State of the art

Thermoelectric generators and coolers are structurally simple devices that can directly convert heat into electricity (generators) and vice versa (coolers). Such converters operate on the basis of two thermoelectric effects discovered by Seebeck and Peltier utilizing the ability of electrons to carry heat and electric charge simultaneously. Since electrons are the only moving elements of such devices they operate noiselessly and without failure for many years. Thus, thermoelectric devices emerge as an alternative for others unconventional methods of energy managing and harvesting (see L.E. Bell, Science 321, 1457 (2008)). The PbTe-based thermoelectrics are for applications in autonomous power supplies, e.g. in space missions.

Methods of obtaining thermoelectric materials are generally known in the art. Polish patent PL217102 discloses a method and furnace assembly for obtaining polycrystals of semiconducting compounds. Examples given comprise also thermoelectric compounds. Polish patent PL215683 discloses a method of obtaining layered nanocomposite of PbTe-CdTe.

Thermoelectric efficiency is described by dimensionless figure of merit parameter known as *ZT* = (*σ·S²*/*κ*) · *T*, where *T* is the temperature, *σ* is the electrical conductivity, *S* and *κ* denote Seebeck coefficient (thermopower) and thermal conductivity, respectively. For currently available best materials it is around 1, what limits their use to specialized or applications like space missions or autonomous power supplies. It is expected that materials reaching *ZT* of about 1 could be the basis for thermoelectric devices that are components of systems operating in a wide temperature range for waste heat management in industry or improving energy efficiency of car's combustion engines (see F.J.J. DiSalvo, Science 285, 703 (1999)).

Good thermoelectric material is characterized by high electric and low thermal conductivities. Lead telluride (PbTe) is one of such materials exhibiting the best thermoelectric performance at temperatures around 300÷500 °C (573÷773 K). In addition to increasing electric conductivity trough appropriate doping (see HORICHOK I V ET AL: "Point defects in PbCdTe solid solutions", JOURNAL OF APPLIED PHYSICS, AMERICAN INSTITUTE OF PHYSICS US), the nanostructuring is one of the new strategies to enhance the thermoelectric effectiveness of known materials. Nanostructuring consists in preparing low-dimensional structures with the use of good thermoelectrics or introducing into them the nano- and micro-grains of the same or other material phases - see WO2006/133031. Reducing the dimensionality of a thermoelectric material increases the Seebeck coefficient *S* by increasing the density of states of electric charge carriers as well as decreases thermal conductivity due to phonon scattering on interfaces in structure (see M. S. Dresselhaus, G. Chen, M. Y. Tang, R. G. Yang, H. Lee, D. Z. Wang, Z. F. Ren, J. P. Fleurial, P. Gogna "New Directions for Low-Dimensional Thermoelectric Materials" Adv. Mater. 19, 1043, (2007)). The introduction of grains of other phases into thermoelectric material or its alloying with other elements is associated with a decrease in its thermal conductivity *κ* due to alloy disorder scattering and grain boundaries scattering of phonons (see W. Liu, X. Yan, G. Chen, and Z. Ren, Nano Energy 1, 42 (2012)). Some of the semiconductor low-dimensional structures based on PbSeTe/PbTe quantum dots exhibit high *ZT* ≈ 3.5 indeed, confirming the validity of the concept (see T. C. Harman, M. P. Walsh, B. E. LaForge, G. W. Turner, J. Electron. Mater. 34, L19 (2005)). However, their use in real applications is firmly limited by the small working volume and costly methods of growing such structures. Therefore, nano-structured bulk materials are expected to be a real breakthrough in significantly increasing the efficiency of thermoelectric devices.

Preparation of Lead Telluride PbTe composite with Cadmium Telluride CdTe is expected to improve good thermoelectric properties of PbTe. It is known that those properties depend on structure and proportions of the composition of Cd ions, but optimal relations were not thoroughly investigated yet.

Since PbTe crystallizes in the rock-salt crystal structure, while CdTe in zinc blende structure, their mutual solubility is strongly limited (see M. Szot, K. Dybko, P. Dziawa, L. Kowalczyk, E. Smajek, V. Domukhovski, B. Taliashvili, P. Dluzewski, A. Reszka, B.J. Kowalski, M. Wiater, T. Wojtowicz, and T. Story, Cryst. Growth Des. 11, (2011), W. Heiss, H. Groiss, E. Kaufmann, G. Hesser, M. Booberl, G. Springholz, F. Schaffler, K. Koike, H. Harada, and M. Yano, Applied Physics Letters 88, 192109 (2006)). Hence, attempts to produce ternary Pb₁₋ₓCdₓTe compounds with relatively high Cd content usually result in a material with undesirable CdTe precipitation embedded in low Cd content (up to 3 at.%) Pb₁₋ₓCdₓTe matrix if using rapid quenching or hot-pressing growth methods. To obtain polycrystalline, single-phase Pb₁₋ₓCdₓTe solid solution material with Cd content of about 10 at. % the rapid quenching method with additional long-term annealing over 14 days at 720 °C was used as it is shown in publication P.M. Nikolic, Br. J. Appl. Phys. 17, 341 (1966), or Bridgman method as shown in L. M. Rogers, A. J. Crocker, J. Phys. D-Appl. Phys. 4, 1006 (1971).

To obtain monocrystalline Pb₁₋ₓCdₓTe solid solution material with higher Cd content up to 10 at. % a self-selecting vapor growth (SSVG) method was successfully used as disclosed by M. Szot, L. Kowalczyk, E. Smajek, V. Domukhovski, J. Domaga 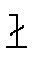 a, E. 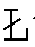 usakowska, B. Taliashvili, P. Dziawa, W. Knoff, M. Wiater, T. Wojtowicz, and T. Story, Acta Phys. Pol. A 114, (2008)). Nevertheless, presence of other phases grains is associated with decreasing of thermal conductivity *κ* of the material. Moreover, addition Cd ions into PbTe crystal lattice causes both up to twofold decrease of *κ* and increase of Seebeck coefficient *S* for x=0.1 (see M. Szot, P. Pfeffer, K. Dybko, A. Szczerbakow, L. Kowalczyk, P. Dziawa, R. Minikayev, T. Zajarniuk, K. Piotrowski, M. U. Gutowska, A. Szewczyk, T. Story, and W. Zawadzki, Phys. Rev. Materials 4, 044605 (2020)). See also Orlowski B A Et Al: "Phototemission spectra of frozen rock salt PbCdTe crystal, JOURNAL OF ELECTRON SPECTROSCOPY AND RELATED PHENOMENA.

While the way for obtaining the low-dimensional layered PbTe-CdTe nanocomposite with total thickness ≈ 1µm by molecular beam epitaxy technique (MBE) has been explored successfully previously in the context of both thermoelectric and optical use (see M. Szot, K. Dybko, P. Dziawa, L. Kowalczyk, E. Smajek, V. Domukhovski, B. Taliashvili, P. Dluzewski, A. Reszka, B.J. Kowalski, M. Wiater, T. Wojtowicz, and T. Story, Cryst. Growth Des. 11, 4794 (2011); G. Karczewski, M. Szot, S. Kret, L. Kowalczyk, S. Chusnutdinow, T. Wojtowicz, S. Schreyeck, K. Brunner, C. Schumacher, and L.W. Molenkamp, Nanotechnology 26, 135601 (2015)), there are only few studies concerning this kind of composite in the form of bulk samples. In those studies, the formation of composite is an effect of non-intentional formation of CdTe precipitates in PbTe resulting from attempts of preparation of high Cd content Pb₁₋ₓCdₓTe solid solutions material.

The publication K. Ahn, M.K. Han, J. He, J. Androulakis, S. Ballikaya, C. Uher, V.P. Dravid, and M.G. Kanatzidis, J. Am. Chem. Soc. 132, 5227 (2010) discloses a method of preparation of PbTe-CdTe bulk material doped additionally with Iodine to tune the carrier concentration, in which the components were prepared in the form of pure Pb, Te, Cd elements and melted in silica tube at temperature near the melting point of CdTe i.e. at 1050 °C (1323 K) for 5 h and cooled slowly to 750 °C (1023 K) in 2 h. After standing at this temperature for next 4 h the tube was cooled to room temperature over 12 h.

It is known from publication G. Tan, X. Zhang, S. Hao, H. Chi, T. P. Bailey, X. Su, C. Uher, V. P. Dravid, Ch. Wolverton, and M. G. Kanatzidis, ACS Appl. Mater. Interfaces 11, 9197 (2019) the method of preparation of Pb_{0.97}Cd_{0.03}Te bulk material doped with Sb in which the ampoule with loaded pure Pb, Te, Cd, Sb elements were heated to 1100 °C (1373 K) over 10 h, soaked at this temperature for next 6 h and then rapidly quenched in ice water. Then the quenched ingots were further annealed at 600 °C (873 K) for 2 days and quenched again. The ingots prepared this way were ground into fine powders by hand and then densified by spark plasma sintering (SPS) method at 550 °C (823 K) for 5 min under an axial compressive stress of 40 MPa in vacuum.

It is an object of the invention to provide a method of obtaining nonocomoposite PbTe-CdTe enabling production of bulk material having very good thermoelectric properties, uniform distribution of CdTe precipitates in the entire volume of the final material and with reduced defects such as craters and voids.

Present invention can be considered as modified Bridgman method of crystal growth used to obtain the PbTe-CdTe nanocomposite in the form of bulk sample of the volume required for applications. The material obtained with the conventional Bridgman method is characterized by polycrystalline structure what is usually undesirable effect but from thermoelectric point of view it may further lower the *κ*, what appears to be a key effect improving *ZT*. According to the invention, this property is deliberately exploited while taking advantage of the tendency to segregate CdTe in PbTe. Of particular importance to this invention are the ability to incorporate of CdTe into the PbTe matrix in the form of CdTe crystallites and control of the amount of built-in Cd to the PbTe crystal lattice. The main advantage of this invention is self-limited solubility of CdTe in PbTe and uniform distribution of CdTe precipitates in the entire volume of the final material.

### Summary of the invention

A method of obtaining of bulk thermoelectric nanocomposite of Lead Telluride and Cadmium Telluride PbTe-CdTe by mixing compounds in temperature in which at least one compound is in a liquid form and subsequently solidifying, according to the invention is characterized in that it comprises step of preparation of an input material including mixing elemental Lead Pb, elemental Tellurium Te and Cadmium telluride CdTe compound to obtain input material and placing input material in an ampoule. Lead Pb and Tellurium Te are provided in identical atomic proportion and mass of Cadmium Telluride CdTe compound is provided in range of 2% to 10% (preferably 2% to 5%) of total molar mass of input material. The method further comprises a step of heating input material to temperature of at least 30°C higher than melting temperature of compound Lead Telluride PbTe but of at least 100°C lower than melting temperature of compound Cadmium Telluride CdTe, during a time of at least 48 hours to obtain dissolved material. This ensures aggregation of CdTe into clusters, and not its complete dissolution in PbTe. The method further comprises a step of rocking the furnace with dissolved material for at least 15 minutes with frequency of 0.5 Hz to obtain homogenized dissolved material, which results in uniform distribution of CdTe in the input material. The method further comprises step of changing ambient temperature to a value lower than melting temperature of Lead Telluride by less than 100°C within a time shorter than 10 s. If the time is longer effects of mixing are diminished and composition is less uniform. The method further comprises a step of solidifying of the homogenized dissolved material for at least 3 hours in temperature lower than melting temperature of Lead Telluride by less than 100°C to obtain the nanocomposite PbTe-CdTe. If the temperature is lower or solidifying is faster risk of defects in bulk structure is increased. It is caused by two phenomena. Firstly, PbTe and CdTe have significantly different thermal expansion coefficients. Secondly inside portion of the bulk structure is cooled in slower pace than the outside portion. Finally, the material is cooled for at least 10 hours. Shorter cooling again results in higher risk of formation of defects.

Advantageously in the step of preparation of the input material a doping of elemental sodium in a atoms/cm³ range between **10¹⁹cm⁻³** and **10²⁰ cm⁻³** is added.

Alternatively in the step of preparation of the input material a doping of elemental bismuth in a atoms/cm³ range between **10¹⁹cm⁻³** and **10²⁰ cm⁻³** is added.

.

### Description of drawings

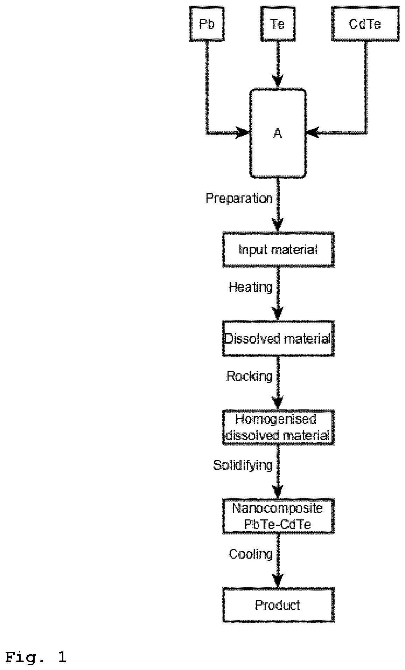

The invention has been described below in detail, with reference to the following figures wherein
Fig. 1 shows schematically process steps of the method according to the invention,
Fig. 2 shows schematically rocking of ampoule with dissolved material in the upper part of the furnace to obtain homogenized dissolved material,
Fig. 3 shows schematically solidifying of the of homogenized dissolved material,
Fig. 4 shows a measurements results of obtained nanocomposite with p-type doping: ZT versus temperature,
Fig. 5 shows a measurements results of obtained nanocomposite with n-type doping: ZT versus temperature.

### Embodiments of the invention

In an example given below a preparation procedure of the (Pb_{0.98}Cd_{0.02}) Te crystal doped with Na for p-type electrical conductivity is described.

Input material comprised pure Lead Pb and Tellurium Te elements as well as Cadmium telluride CdTe in a compound form. Components were prepared in weight proportions as follows: Pb -24.39694 g; Te - 15.02627 g; compound CdTe - 0.57679 g; Na - 0.0191 g.

Best results were obtained with Lead **Pb** of purity of N5 (99.999%) provided as a rod of diameter of 6 mm, and cut into pieces. Tellurium **Te** of purity of N6 and compound **CdTe** of purity N6 were provided in form of chipping. Components were mixed and crumbed in mortar to obtain grains having dimension of c.a. 1 mm, except for Lead **Pb** which was not prone to crumbing. That is however of little consequence as melting temperature of **Pb** is low 327 °C (600 K).

The components sealed in quartz ampule with diameter of 20 mm, evacuated to the pressure of about 10⁻⁶ Torr, were placed in two-zone electric furnace. Specifically furnace according to Polish patent PL217102 was used.

Initially, sealed ampoule was placed in upper part of the furnace, having higher temperature while the bottom part of the furnace was kept at lower temperature. After that, the upper part of the furnace was heated to 950 °C (1223 K) for 48 hours - i.e. to temperature 33 °C above the melting point of PbTe (917 °C) but significantly below the melting point of CdTe (1092 °C). This choice of components and temperature prevented the dissolution of the CdTe compound in PbTe. In this step dissolved material was applied.

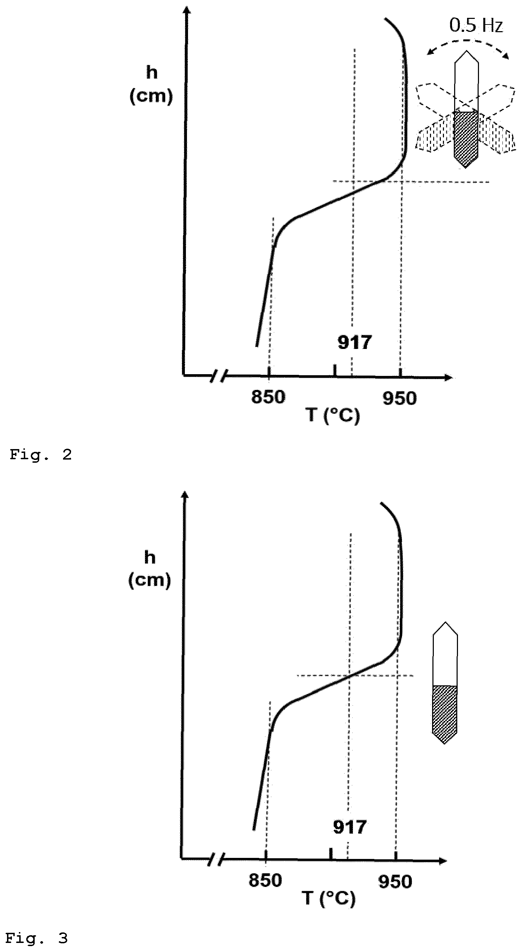

The temperature of the lower part of the furnace was kept at 850 °C i. e. below the melting point of PbTe (917 °C). After complete dissolution of input material at temperature 950 °C, the furnace was rocked from a vertical to a horizontal position with frequency of 0.5 Hz for 15 minutes as schematically shown in Fig. 2. Rocking of dissolved material resulted in obtaining homogenized dissolved material PbTe with uniformly distributed CdTe.

The furnace was then stopped in an upright position and the ampoule was quickly - in 5 seconds - lowered in it so that the part of the ampoule with the dissolved material was below the crystallization point of PbTe and the upper, empty part of the ampoule was still above the crystallization point of PbTe as it is shown in Fig. 3.

Higher temperature in the upper part of the ampoule protects the rapidly cooled material against defects such as craters and voids. Rapid cooling of the material after mixing by rocking the furnace ensures a uniform distribution of CdTe precipitations over the entire volume of the final crystal material. The ampoule was kept in the position shown in Fig 3 for 3-4 hours and then the furnace was turned off to cool the crystal to room temperature over 10 hours.

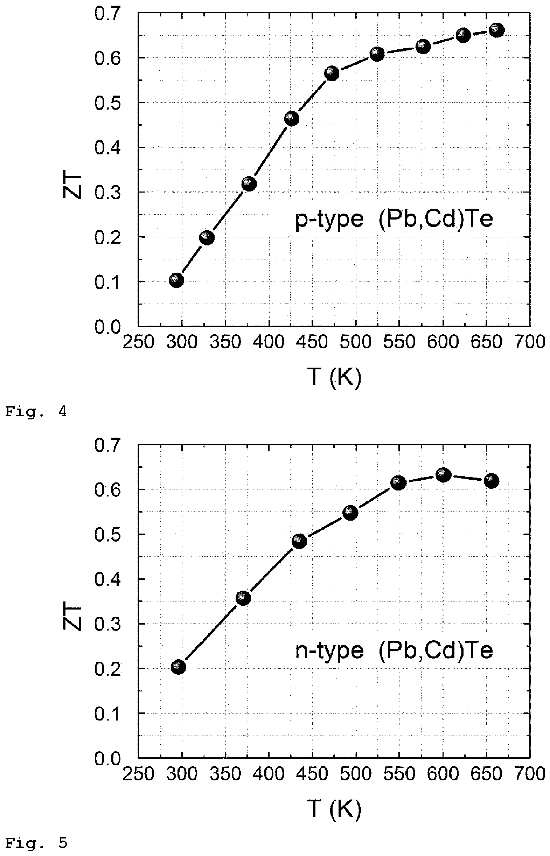

The method resulted in nanocomposite having areas of Cadmium telluride CdTe precipitations uniformly distributed in bulk Lead telluride PbTe. Because of doping with Sodium (10¹⁹ atoms / cm³) ) the nanocomposite was p-semiconductor. It shown excellent *ZT* factor at 650 K. Plot showing values of *ZT* versus temperature as measured by the Harman method is shown in Fig. 4.

In another embodiment 0.0521 g doping of Bismuth (c.a 7.10¹⁹ atoms / cm³) was applied instead of doping of Sodium. That resulted in n-type semiconductor. Plot showing *ZT* factor versus temperature is shown in Fig. 5. This is quite unique property of a method of preparation of the thermoelectric material to be as suitable for n-type as for p-type conductivity. It makes it considerably easier to apply in various kinds of industrial processes.

Comparison of Fig. 4 and Fig. 5 shows that bulk nanocomposite obtained with the method according to the invention shows very good thermoelectric properties with both p-type and n-type conductivity. Generally doping between 1.10¹⁹ atoms/cm³ and 1·10²⁰ atoms/cm³ has given good results. Good results were obtained for molar mass 2% to 10% of **CdTe.** Best results were in obtained for 2% to 5%. It is quite clear that optimization of doping. in particular kind of doping or amount of Na or Bi may further improve ZT.

The method utilizes the extremely low mutual solubility of said semiconductors and is based on novel combination of the modified Bridgman growth method with proper preparation of constituent substances. The method can be easily implemented in industry as it is based on basic material properties and requires non-advanced equipment in contrast to other methods of obtaining thermoelectric nanocomposite materials known in the art.

Obtained bulk material has very good thermoelectric properties related to uniform distribution of CdTe precipitation in PbTe. Bulk form is crucial for applications related to use of higher electric power.

## Claims

1. A method of obtaining of bulk nanocomposite of Lead Telluride and Cadmium Telluride **(PbTe-CdTe)** by mixing compounds in temperature in which at least one compound is in a liquid form and subsequently solidifying, **characterized in that** it comprises
a step of preparation of an input material including mixing elemental Lead (**Pb**), elemental Tellurium (**Te**) and Cadmium telluride **(CdTe)** compound to obtain input material and placing input material in a quartz ampoule, wherein
Lead (**Pb**) and Tellurium (**Te**) are provided in equal atomic proportion
and mass of Cadmium Telluride **(CdTe)** compound is provided in range of 2% to 10% of total molar mass of input material,
a step of heating input material to temperature of at least 30°C higher than melting temperature of compound Lead Telluride (**PbTe**) but of at least 100°C lower than melting temperature of compound Cadmium Telluride (**CdTe**), during a time of at least 48 hours to obtain dissolved material,
a step of rocking the furnace with dissolved material for at least 15 minutes with frequency of at least 0.5 Hz to obtain homogenized dissolved material,
a step of lowering ambient temperature to a value lower than melting temperature of Lead Telluride by less than 100°C within a time shorter than 10 s,
a step of solidifying of the homogenized dissolved material for at least 3 hours in temperature lower than melting temperature of lead telluride by less than 100°C to obtain the nanocomposite (**PbTe-CdTe**),
a step of cooling for at least 10 hours.

2. Method according to claim 1, **characterized in that** in the step of preparation of the input material a doping of elemental sodium in a range between 10¹⁹*atoms*/cm³ and 10²⁰ atoms/cm³ is added.

3. Method according to claim 1, **characterized in that** in the step of preparation of the input material a doping of elemental bismuth in a range between 10¹⁹*atoms*/cm³ and 10²⁰ *atoms*/cm³ is added.

## Patentansprüche

1. Verfahren zum Herstellen eines Bulk-Nanokomposits aus Bleitellurid und Cadmiumtellurid (**PbTe-CdTe**) durch Mischen von Verbindungen bei einer Temperatur, bei der mindestens eine Verbindung in flüssiger Form vorliegt, und danach Erstarrenlassen, **dadurch gekennzeichnet, dass** es umfasst:
einen Schritt des Vorbereitens eines Einsatzmaterials, umfassend das Mischen von elementarem Blei **(Pb),** elementarem Tellur **(Te)** und der Verbindung Cadmiumtellurid (**CdTe**), um das Einsatzmaterial herzustellen, und das Platzieren des Einsatzmaterials in eine Quarzampulle, wobei
Blei **(Pb)** und Tellur **(Te)** in gleich großem Atomanteil bereitgestellt werden
und die Masse der Verbindung Cadmiumtellurid **(CdTe)** im Bereich von 2 % bis 10 % der gesamten Molmasse des Einsatzmaterials bereitgestellt wird,
einen Schritt des Erwärmens des Einsatzmaterials auf eine Temperatur, die mindestens 30 °C höher als die Schmelztemperatur der Verbindung Bleitellurid (**PbTe**), aber mindestens 100 °C niedriger als die Schmelztemperatur der Verbindung Cadmiumtellurid **(CdTe)** ist, während einer Zeit von mindestens 48 Stunden, um gelöstes Material herzustellen,
einen Schritt des Schwenkens des Ofens mit dem gelösten Material über mindestens 15 Minuten mit einer Frequenz von mindestens 0,5 Hz, um homogenisiertes gelöstes Material herzustellen,
einen Schritt des Verringerns der Umgebungstemperatur auf einen Wert, der um weniger als 100 °C niedriger als die Schmelztemperatur von Bleitellurid ist, innerhalb einer Zeit, die kürzer als 10 s ist,
einen Schritt des Erstarrenlassens des homogenisierten gelösten Materials über mindestens 3 Stunden bei einer Temperatur, die um weniger als 100 °C niedriger als die Schmelztemperatur von Bleitellurid ist, um das Nanokomposit **(PbTe-CdTe)** herzustellen,
einen Schritt des Abkühlens über mindestens 10 Stunden.

2. Verfahren nach Anspruch 1, **dadurch gekennzeichnet, dass** in dem Schritt des Vorbereitens des Einsatzmaterials eine Dotierung aus elementarem Natrium in einem Bereich zwischen 10¹⁹ Atomen/cm³ und 10²⁰ Atomen/cm³ hinzugefügt wird.

3. Verfahren nach Anspruch 1, **dadurch gekennzeichnet, dass** in dem Schritt des Vorbereitens des Einsatzmaterials eine Dotierung aus elementarem Bismut in einem Bereich zwischen 10¹⁹ Atomen/cm³ und 10²⁰ Atomen/cm³ hinzugefügt wird.

## Revendications

1. Procédé pour obtenir un nanocomposite en vrac de tellurure de plomb et de tellurure de cadmium **(PbTe-CdTe)** par mélangeage de composés à une température à laquelle au moins un composé se trouve sous une forme liquide puis solidification, **caractérisé en ce qu'**il comprend
une étape de préparation d'une matière première comprenant le mélangeage de plomb élémentaire **(Pb),** de tellurium élémentaire **(Te)** et de composé tellurure de cadmium **(CdTe)** pour obtenir la matière première, et la mise en place de la matière première dans une ampoule en quartz, dans lequel
le plomb **(Pb)** et le tellurium **(Te)** sont apportés en proportion atomique égale
et la masse du composé tellurure de cadmium **(CdTe)** est apportée à raison de 2 % à 10 % de la masse molaire totale de la matière première,
une étape de chauffage de la matière première à une température supérieure d'au moins 30 °C à la température de fusion du composé tellurure de plomb (**PbTe**) mais inférieure d'au moins 100 °C à la température de fusion du composé tellurure de cadmium (**CdTe**), pendant une durée d'au moins 48 heures pour obtenir une matière dissoute,
une étape d'oscillation du four avec la matière dissoute, pendant au moins 15 minutes, avec une fréquence d'au moins 0,5 Hz pour obtenir une matière dissoute homogénéisée,
une étape d'abaissement de la température ambiante à une valeur inférieure de moins de 100 °C à la température de fusion du tellurure de plomb dans un laps de temps inférieur à 10 s,
une étape de solidification de la matière dissoute homogénéisée, pendant au moins 3 heures, à une température inférieure de moins de 100 °C à la température de fusion du tellurure de plomb pour obtenir le nanocomposite (**PbTe-CdTe**),
une étape de refroidissement pendant au moins 10 heures.

2. Procédé selon la revendication 1, **caractérisé en ce que** dans l'étape de préparation de la matière première un dopage de sodium élémentaire dans une plage comprise entre 10¹⁹ atomes/cm³ et 10²⁰ atomes/cm³ est ajouté.

3. Procédé selon la revendication 1, **caractérisé en ce que** dans l'étape de préparation de la matière première un dopage de bismuth élémentaire dans une plage comprise entre 10¹⁹ atomes/cm³ et 10²⁰ atomes/cm³ est ajouté.
